# EUROPÄISCHE PATENTSCHRIFT

(11) **EP 3 071 466 B1**
(45) Veröffentlichungstag und Bekanntmachung des Hinweises auf die Patenterteilung: **30.09.2020**
(21) Anmeldenummer: 14702760.1
(22) Anmeldetag: 15.01.2014
(51) Int. Cl.: B61C 17/00

(54) **DRUCKLUFTGERÜST EINER ELEKTRISCHEN LOKOMOTIVE**
COMPRESSED-AIR RACK FOR AN ELECTRIC LOCOMOTIVE
STRUCTURE PNEUMATIQUE D'UNE LOCOMOTIVE ÉLECTRIQUE

(43) Veröffentlichungstag der Anmeldung: 28.09.2016
(73) Patentinhaber: Siemens Mobility GmbH, 81739 München (DE)
(72) Erfinder: STOFF, Helmut, 83627 Warngau (DE)
(86) Internationale Anmeldenummer: PCT/EP2014/050647
(87) Internationale Veröffentlichungsnummer: WO 2015/106803

(56) Entgegenhaltungen:
- CN-A- 103 280 696
- CN-U- 201 769 831
- CN-U- 202 320 375
- DE-A1-102008 009 217

## Beschreibung

Die Erfindung betrifft ein Druckluftgerüst einer elektrischen Lokomotive mit einer Elektrik-Baueinheit, die zwischen Blechwänden des Druckluftgerüsts eingefügt ist und von vorn zugängliche, elektrische Module aufweist. Dabei wird unter einer elektrischen Lokomotive sowohl eine rein elektrisch betriebene Lokomotive als auch eine dieselelektrische Lokomotive verstanden.

Ein Druckluftgerüst dieser Art wird bei elektrischen und dieselelektrischen Lokomotiven der Siemens AG benutzt. Diese Druckluftgerüste umfassen dicht gepackt die sogenannte pneumatische Bremstafel, einen Kompressor, einen Trockner, einen Filter, einen Behälter für Hauptluft und Hilfsluft sowie weitere Zusatzgeräte und auch eine Elektrik-Baueinheit zur Steuerung. Die Elektrik-Baueinheit ist dabei als ein Elektronikschrank ausgebildet, der mit den benötigten elektrischen Modulen bestückt ist. Der fertig bestückte Elektronikschrank wird im Druckluftgerüst untergebracht, das so ausgeführt ist, dass es die aus dem Gewicht des Elektronikschranks resultierenden Kräfte aufnehmen kann. Der Elektronikschrank ist dabei auf einer Bodenplatte des Druckluftgerüstes montiert; die weitere Abstützung des Elektronikschranks erfolgt oben durch eine Rückwand des Druckluftgerüstes. Ein derartiges Druckluftgerüst ist aus der Offenlegungsschrift DE 10 2008 009 217 A1 bekannt.

Der Erfindung liegt die Aufgabe zugrunde, ein Druckluftgerüst vorzuschlagen, das sich hinsichtlich seiner Elektrik-Baueinheit vergleichsweise kostengünstig herstellen lässt und in dem sich die Elektrik-Baueinheit relativ einfach einbauen lässt.

Zur Lösung dieser Aufgabe weist bei einem Druckluftgerüst der eingangs angegebenen Art erfindungsgemäß die Elektrik-Baueinheit ein Gestell auf, das mit offenen Seiten und rückwandfrei rahmenartig mit versteifenden Querrippen ausgebildet ist; an den Querrippen sind elektrische Module angebracht.

Ein wesentlicher Vorteil des erfindungsgemäßen Druckluftgerüsts besteht darin, dass es hinsichtlich seiner Elektrik-Baueinheit im Wesentlichen mit einem Geräteträger in Form eines rahmenartigen Gestells auskommt. Den seitlichen und rückwärtigen Abschluss des Gestells bilden nach erfolgter Montage Seitenwände bzw. seitliche Rippen und die Rückwand des aufnehmenden Gerüsts, die ohnehin aus statischen Gründen erforderlich sind. Ein weiterer Vorteil besteht darin, dass bei der Bestückung des Gestells des erfindungsgemäßen Druckluftgerüsts eine gute Zugänglichkeit gewährleistet ist, weil in das Gestell sowohl in üblicher Weise von der Frontseite als auch hier zusätzlich von der Seite und der Rückseite eingegriffen werden kann. Die versteifenden Querrippen behindern dabei die Montage der elektrischen Module kaum.

Erfindungsgemäß liegen die Querrippen an der Vorderseite des Gestells.

Das Gestell der Elektrik-Baueinheit des erfindungsgemäßen Druckluftgerüsts kann in unterschiedlicher Weise hergestellt werden, beispielsweise aus mehreren Einzelteilen, die miteinander verschraubt oder vernietet werden. Besonders vorteilhaft ist es jedoch schon aus Kostengründen, wenn das Gestell ein einteiliges Blechbiegeteil ist, weil dann zusätzliche Verbindungsschritte zur Herstellung des Gestells nicht erforderlich sind.

Zur Versteifung des Gestells der Elektrik-Baueinheit des erfindungsgemäßen Druckluftgerüsts tragen die Querrippen an ihrer Rückseite U-förmige Montagebleche die mit einer Längsrippe verbunden sind, und die Längsrippe oben und unten mit der Rückseite des Gestells verbunden ist. Bei einer weiteren vorteilhaften Ausführungsform des erfindungsgemäßen Druckluftgerüsts sind die Seitenwände des Gestells mit Ausnehmungen zur Aufnahme elektrischer Module versehen. In diesem Zusammenhang ist darauf hinzuweisen, dass im Rahmen der Erfindung auch die Anbringung von elektrischen Modulen an den Seitenwänden des Gestells möglich und durch die offene Bauweise des Gestells erleichtert ist.

Vorteilhaft ist es ferner, wenn an der Vorderseite des Gestells abdichtende Seitenbleche angebracht sind, wodurch das Gestell der Elektrik-Baueinheit des erfindungsgemäßen Druckluftgerüsts die Qualität im Hinblick auf eine Abdichtung erfährt, wie sie sonst nur mit aufwendigen Schränken erreichbar ist.

In vorteilhafter Weise sind bei dem erfindungsgemäßen Druckluftgerüst an einem Seitenblech Anschläge zur Halterung einer Fronttür angebracht.

Ferner wird es als vorteilhaft angesehen, wenn auf das Gestell ein versteifender Deckel aufgesetzt ist.

Das Gestell der Elektrik-Baueinheit des erfindungsgemäßen Druckluftgerüsts kann in unterschiedlicher Weise mit dem Druckluftgerüst verbunden werden; als vorteilhaft wird es angesehen, wenn das Gestell mit dem Druckluftgerüst verschraubt ist.

Das erfindungsgemäße Druckluftgerüst ermöglicht in besonders vorteilhafter Weise, die Elektrik-Baueinheit mit ihrem Gestell unmittelbar zwischen die Blechwände des Druckluftgerüsts unter Bildung einer allseitig geschlossenen Baugruppe einzufügen. Es ist damit ohne zusätzliche Seitenwände und eine Rückwand eine Anordnung gebildet, die mit einem herkömmlichen Elektronikschrank vergleichbar ist.

Zur weiteren Erläuterung der Erfindung ist in
- Fig.1: ein Ausführungsbeispiel eines Gestells der Elektrik-Baueinheit eines Druckluftgerüsts mit aufgesetzten Seitenwänden in einer Schrägansicht seitlich von vorn, in
- Fig.2: eine Rückansicht auf dasselbe Ausführungsbeispiel gemäß Figur 1 schräg von hinten, in
- Fig.3: dasselbe Ausführungsbeispiel eines Gestells mit bereits montierten elektrischen Modulen, in
- Fig.4: dasselbe Ausführungsbeispiel beim Einbringen in ein Druckluftgerüst mit gerade aufgesetztem Deckel und in
- Fig.5: das Druckluftgerüst mit eingebrachter ElektrikBaueinheit gezeigt.

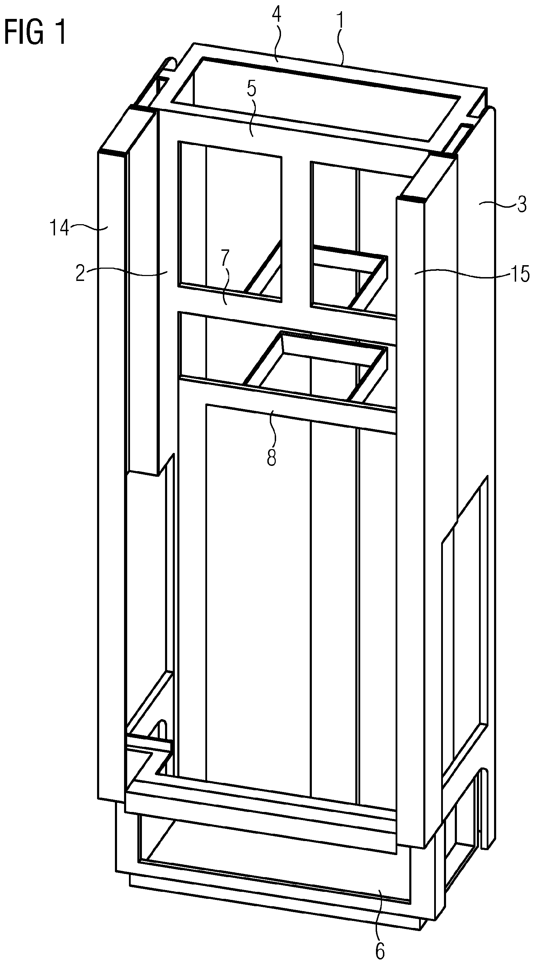

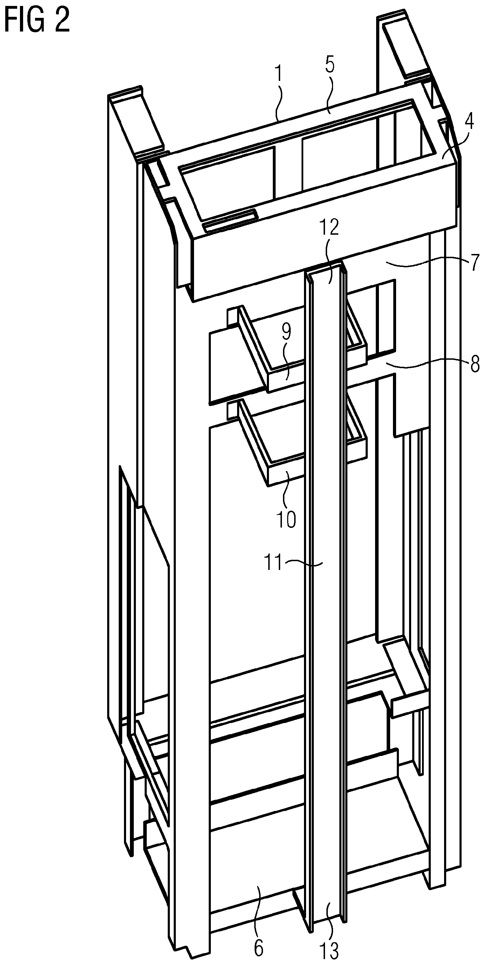

Die Figuren 1 und 2 zeigen ein Gestell 1 einer ansonsten hier nicht weiter dargestellten Elektrik-Baueinheit eines ebenfalls hier nicht wiedergegebenen Druckluftgerüsts. Das Gestell 1 ist rahmenartig ausgebildet, indem es weder eine Vorderseite noch eine Rückseite besitzt, sondern lediglich offene Seitenwände 2 und 3, die an der Oberseite des Gestells 1 mittels oberer Verbindungsbleche 4 und 5 und unten mittels eines Bodenbleches 6 miteinander verbunden sind. Das Gestell 1 weist ferner eine Querrippe 7 und eine weitere Querrippe 8 auf, die jeweils an der Vorderseite des Gestells 1 die Seitenwände 2 und 3 versteifend miteinander verbinden.

Wie insbesondere die Figur 2 erkennen lässt, sind an der Querrippe 7 sowie an der weiteren Querrippe 8 U-förmige Montagebleche 9 und 10 befestigt. Mit diesen Montageblechen 9 und 10 ist eine Längsrippe 11 verbunden, die an ihrem oberen Ende 12 mit dem oberen Verbindungsblech 4 und an ihrem unteren Ende 13 im Bereich des Bodenblechs 6 mit dem Gestell 1 verbunden ist.

Wie vor allem Figur 1 zeigt, ist an der Vorderseite des Gestells 1 ein Seitenblech 14 sowie ein weiteres Seitenblech 15 angebracht, die in nicht dargestellter Weise dichtend mit den Seitenwänden 2 und 3 des Gestells 1 verbunden sind.

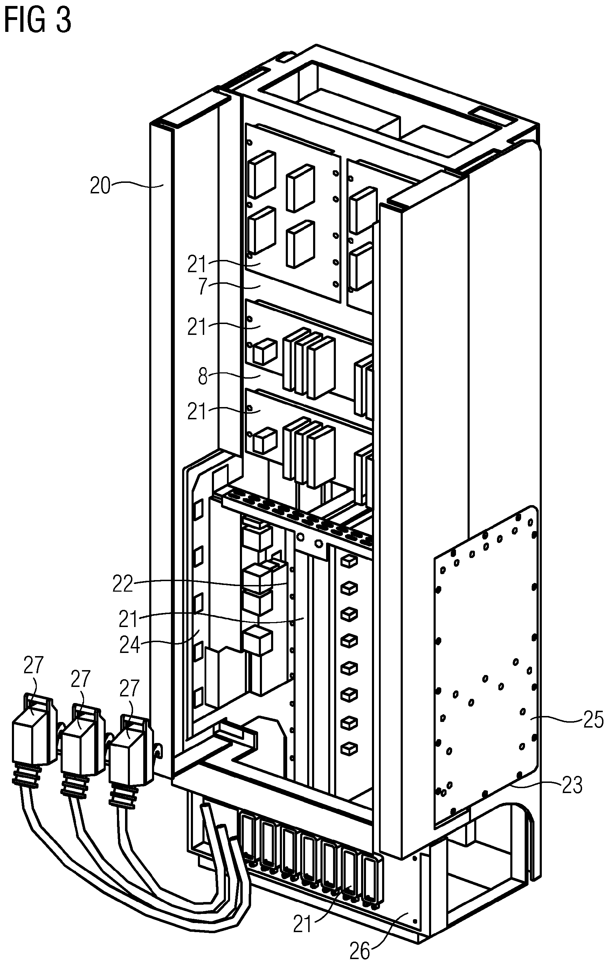

Figur 3 zeigt die nahezu komplett fertiggestellte Elektrik-Baueinheit 20 mit elektrischen Modulen 21, wie sie auch bei Schrankausführungen von Elektrik-Baueinheiten Verwendung finden. Es ist hier zu erkennen, dass diese elektrischen Module 21 nicht nur an den Querrippen 7 und 8 befestigt sind, sondern auch in Ausnehmungen 22 und 23 in Form von weiteren elektrischen Modulen 24 und 25 eingebracht sind. Die Figur 3 zeigt ferner, dass in einem unteren Bereich der Elektrik-Baueinheit 20 zusätzliche elektrische Module 26 untergebracht sind. Ebenso ist zu erkennen, dass aus der Elektrik-Baueinheit 20 Leitungen zu äußeren Anschlusselementen 27 geführt sind.

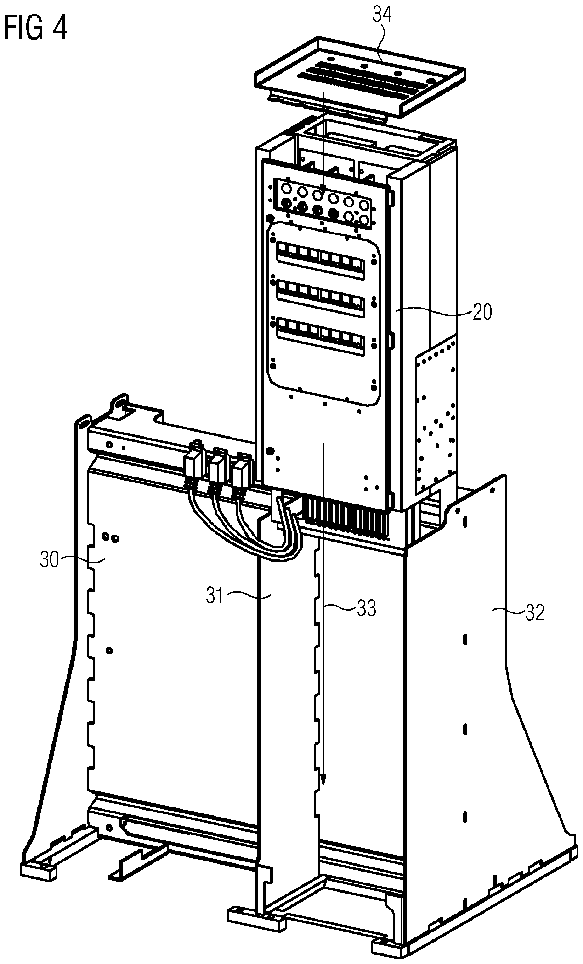

Figur 4 zeigt ein Druckluftgerüst 30, wie es im Rahmen der Erfindung Verwendung finden kann. Es ist zu erkennen, dass das Druckluftgerüst 30 Blechwände 31 und 32 aufweist, die einen Aufnahmeraum für die Elektrik-Baueinheit 20 bilden. Im dargestellten Zustand ist gezeigt, wie gerade die Elektrik-Baueinheit 20 in Richtung des Pfeils 33 zwischen die Blechwände 31 und 32 in das Druckluftgerüst 30 eingeführt wird, wobei mittels eines Deckels 34 im aufgesetzten Zustand eine zusätzliche Versteifung und ein Abschluss der Elektrik-Baueinheit 20 bewirkt wird.

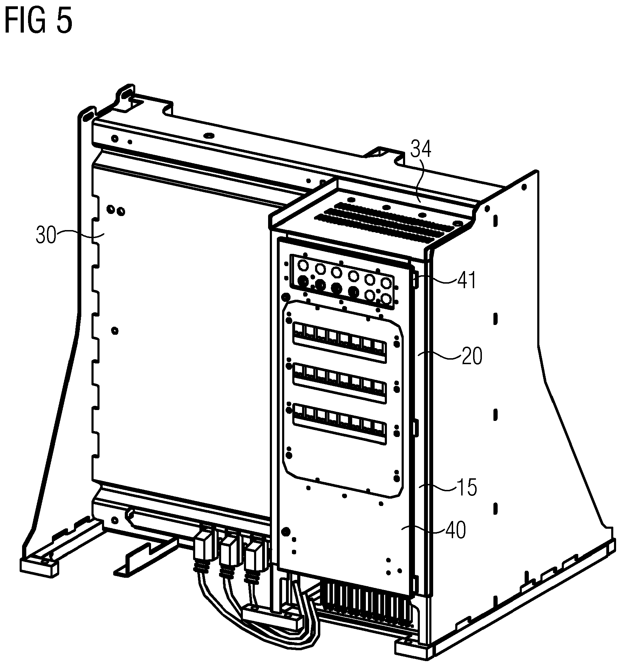

Figur 5 schließlich zeigt die Elektrik-Baueinheit 20 in einem in das Druckluftgerüst 30 eingebauten Zustand mit einer Fronttür 40, die an einem Seitenblech 15 mittels Anschlägen 41 angeschlagen ist. Der Deckel 34 befindet sich hier im aufgesetzten Zustand.

## Patentansprüche

1. Druckluftgerüst (30) einer elektrischen Lokomotive, wobei das Druckluftgerüst eine Elektrik-Baueinheit (20) aufweist, die zwischen Blechwänden (31, 32) des Druckluftgerüsts (30) eingefügt ist und von vorn zugängliche, elektrische Module (21, 24, 25) aufweist,
- bei dem die Elektrik-Baueinheit (20) ein Gestell (1) aufweist, das mit offenen Seiten und rückwandfrei rahmenartig mit versteifenden Querrippen (7, 8) ausgebildet ist,
- bei dem an den Querrippen (7, 8) elektrische Module (21) angebracht sind,
- bei dem die Querrippen (7, 8) an der Vorderseite des Gestells (1) liegen,
- bei dem die Querrippen (7, 8) an ihrer Rückseite U-förmige Montagebleche (9, 10) tragen, die mit einer Längsrippe (11) verbunden sind, und
- bei dem die Längsrippe (11) oben und unten mit der Rückseite des Gestells (1) verbunden ist.

2. Druckluftgerüst (30) nach Anspruch 1, bei dem das Gestell (1) ein einteiliges Blechbiegeteil ist.

3. Druckluftgerüst (30) nach einem der vorangehenden Ansprüche, bei dem Seitenwände des Gestells (1) mit Ausnehmungen (22, 23) zur Aufnahme elektrischer Module (24, 25) versehen sind.

4. Druckluftgerüst (30) nach Anspruch 1, bei dem an der Vorderseite des Gestells (1) abdichtende Seitenbleche (14, 15) angebracht sind.

5. Druckluftgerüst (30) nach Anspruch 4, bei dem an einem Seitenblech (15) Anschläge (41) zur Halterung einer Fronttür (40) angebracht sind.

6. Druckluftgerüst (30) nach einem der vorangehenden Ansprüche, bei dem auf das Gestell (1) ein versteifender Deckel (34) aufgesetzt ist.

7. Druckluftgerüst (30) nach einem der vorangehenden Ansprüche, bei dem das Gestell (1) mit dem Druckluftgerüst (30) verschraubt ist.

8. Druckluftgerüst (30) nach einem der vorangehenden Ansprüche, bei dem die Elektrik-Baueinheit (20) mit ihrem Gestell (1) unmittelbar zwischen die Blechwände (31, 32) des Druckluftgerüsts (30) unter Bildung einer allseitig geschlossenen Baugruppe eingefügt ist.

## Claims

1. Compressed-air rack (30) of an electric locomotive, wherein the compressed-air rack comprises an electric assembly (20), which is inserted between sheet metal walls (31,32) of the compressed-air rack (30), and comprises electric modules (21,24,25) which are accessible from the front,
- in which the electric assembly (20) has a frame (1), that has no rear wall and has open sides and reinforcing cross ribs (7,8),
- in which electric modules (21) are attached to the cross ribs (7, 8),
- in which the cross ribs (7, 8) are located on the front side of the frame (1),
- in which on their rear side the cross ribs (7,8) support U-shaped mounting plates (9,10) which are connected to a longitudinal rib (11), and
- in which the longitudinal rib (11) is connected above and below to the rear side of the frame (1).

2. Compressed-air rack (30) according to claim 1,
in which
the frame (1) is a single-piece flexible sheet metal part.

3. Compressed-air rack (30) according to one of the preceding claims,
in which
side walls of the frame (1) are provided with recesses (22,23) for receiving electric modules (24,25).

4. Compressed-air rack (30) according to claim 1,
in which
sealing side plates (14,15) are attached to the front side of the frame (1).

5. Compressed-air rack (30) according to claim 4,
in which stops (41) for supporting a front door (40) are attached to a side plate (15).

6. Compressed-air rack (30) according to one of the preceding claims,
in which
a reinforcing cover (34) is fitted to the frame (1).

7. Compressed-air rack (30) according to one of the preceding claims,
in which the frame (1) is screwed to the compressed-air rack (30) .

8. Compressed-air rack (30) according to one of the preceding claims,
in which the electric assembly (20) is inserted with its frame (1) directly between the sheet metal walls (31, 32) of the compressed-air rack (30) by forming a module which is enclosed on all sides.

## Revendications

1. Structure pneumatique (30) d'une locomotive électrique, la structure pneumatique comprenant une unité physique électrique (20) qui est insérée entre des parois en tôle (31, 32) de la structure pneumatique (30) et comprend des modules électriques (21, 24, 25) accessibles depuis l'avant,
- dans laquelle l'unité physique électrique (20) comprend un bâti (1) qui est réalisé avec des côtés ouverts et, à la manière d'un cadre sans paroi arrière, avec des nervures transversales de renforcement (7, 8),
- dans laquelle des modules électriques (21) sont montés sur les nervures transversales (7, 8),
- dans laquelle les nervures transversales (7, 8) sont situées sur le côté avant du bâti (1),
- dans laquelle les nervures transversales (7, 8) portent sur leur côté arrière des tôles de montage en forme de U (9, 10) qui sont reliées à une nervure longitudinale (11), et
- dans laquelle la nervure longitudinale (11) est reliée, en haut et en bas, au côté arrière du bâti (1).

2. Structure pneumatique (30) selon la revendication 1, dans laquelle le bâti (1) est une pièce pliée en tôle d'un seul bloc.

3. Structure pneumatique (30) selon l'une des revendications précédentes, dans laquelle des parois latérales du bâti (1) sont pourvues d'évidements (22, 23) destinés à recevoir des modules électriques (24, 25).

4. Structure pneumatique (30) selon la revendication 1, dans laquelle des tôles latérales (14, 15) assurant une étanchéité sont installées sur le côté avant du bâti (1).

5. Structure pneumatique (30) selon la revendication 4, dans laquelle des butées (41) destinées à la fixation d'une porte avant (40) sont montées sur une tôle latérale (15).

6. Structure pneumatique (30) selon l'une des revendications précédentes, dans laquelle un couvercle raidisseur (34) est posé sur le bâti (1).

7. Structure pneumatique (30) selon l'une des revendications précédentes, dans laquelle le bâti (1) est vissé à la structure pneumatique (30).

8. Structure pneumatique (30) selon l'une des revendications précédentes, dans laquelle l'unité physique électrique (20) est insérée avec son bâti (1) directement entre les parois en tôle (31, 32) de la structure pneumatique (30), formant ainsi un ensemble fermé sur tous les côtés.
